# EUROPEAN PATENT APPLICATION

(11) **EP 3 872 990 A1**
(43) Date of publication of application: **01.09.2021**
(21) Application number: 20160172.1
(22) Date of filing: 28.02.2020
(51) Int. Cl.: H03K 17/16

(54) **SEMICONDUCTOR SWITCHING ASSEMBLY AND GATE DRIVER CIRCUIT**

(71) Applicant: Infineon Technologies AG, 85579 Neubiberg (DE)
(72) Inventor: ECKEL, Hans-Guenter, 18059 Rostock (DE); FUHRMANN, Jan, 18057 Rostock (DE); STOERMER, Florian, 18055 Rostock (DE)
(74) Representative: Müller Hoffmann & Partner

(57) **Abstract**

A semiconductor switching assembly (900) includes a gate driver circuit (600), a diode structure (550) and supplementary circuit (660). The gate driver circuit (600) is configured to drive a gate signal for a voltage controlled switching device (590). The gate signal is output between a gate output terminal (Gout) and a reference voltage terminal (Vref). The gate signal may assume an active state and an inactive state. The diode structure (550) is electrically arranged between the gate output terminal (Gout) and the reference voltage terminal (Vref). The diode structure (550) is arranged to be reverse biased when the voltage controlled switching device (590) is on. The supplementary circuit (660) is configured to temporarily impose a forward current (IF) through the diode structure (550).

## Description

### TECHNICAL FIELD

Examples of the present disclosure relate to a gate driver circuit and to a semiconductor switching assembly including a gate driver circuit for semiconductor switches such as MOSFETs (metal oxide semiconductor field effect transistors), SiC MOSFETs (silicon carbide MOSFETs), IGBTs (insulated gate bipolar transistors) and HEMTs (high electron mobility transistors).

### BACKGROUND

Opposite polarities for the gate drive voltages for turning on and turning off a voltage controlled semiconductor switch may prevent unintended turn-on of the semiconductor switch but may adversely affect the performance of the semiconductor switch in the long term. One aspect to be considered for SiC MOSFETs is a possible drift of gate threshold voltage VGS(th) under long-term operation. A dynamic component of the gate threshold voltage drift may depend on the switching frequency and the selected gate-to-source voltage for turn-off VGS(off). For example, negative voltages at the gate terminal may promote a gate threshold voltage drift. Design guidelines aiming at limiting the increase of SiC MOSFET on-state resistance RDS(on) recommend a certain operating area for the minimum turn-off voltage VGS(off), the switching frequency, and the turn-on voltage VGS(on).

There is a need for improving long-term stability and reliability of voltage controlled semiconductor devices at low additional circuit complexity.

### SUMMARY

An embodiment of the present disclosure relates to a semiconductor switching assembly. The semiconductor switching assembly includes a gate driver circuit, a diode structure and supplementary circuit. The gate driver circuit is configured to drive a gate signal for a voltage controlled switching device. The gate signal is output between a gate output terminal and a reference voltage terminal. The gate signal may assume an active state and an inactive state. The diode structure is electrically arranged between the gate output terminal and the reference voltage terminal. The diode structure is arranged to be reverse biased when the voltage controlled switching device is on. The supplementary circuit is configured to temporarily impose a forward current through the diode structure

Another embodiment of the present disclosure relates to a half-bridge gate driver device. The half-bridge gate driver device includes a gate driver circuit configured to drive a first gate signal for a first voltage controlled switching device and to drive a second gate signal for a second voltage controlled switching device. The first gate signal is inactive when the second gate signal is active. The second gate signal is inactive when the first gate signal is active. The half-bridge gate driver device further includes a control circuit with a first control output node. The control circuit is configured to generate a first control signal at the first control output node. The first control signal becomes active after a transition of the first gate signal from active to inactive and prior to a subsequent transition of the second gate signal from inactive to active. The first control signal becomes inactive after the transition of the second gate signal from inactive to active and prior to a subsequent transition of the first gate signal from inactive to active.

Another embodiment of the present disclosure relates to a single-switch gate driver device. The single-switch gate driver device includes a gate driver circuit and a control circuit. The gate driver circuit is configured to drive a gate signal for a voltage controlled switching device. The control circuit includes a first control output node and is configured to generate a first single-switch control signal at the first control output node. The first single-switch control signal becomes active with or after a transition of the gate signal from active to inactive. The first single-switch control signal becomes inactive with or prior to a subsequent transition of the gate signal from inactive to active.

Those skilled in the art will recognize additional features and advantages upon reading the following detailed description and on viewing the accompanying drawings.

### BRIEF DESCRIPTION OF THE DRAWINGS

The accompanying drawings are included to provide a further understanding of the embodiments and are incorporated in and constitute a part of this specification. The drawings illustrate embodiments of a semiconductor switching assembly and a gate driver circuit and together with the description serve to explain principles of the embodiments. Further embodiments are described in the following detailed description and the claims.
FIG. 1 shows a simplified circuit diagram of a semiconductor switching assembly including a gate driver circuit, a diode structure, and a supplementary circuit according to an embodiment.
FIG. 2 shows a simplified circuit diagram of a semiconductor switching assembly according to an embodiment including a voltage controlled switching device and a controllable current source.
FIG. 3 shows a simplified timing diagram for the controllable current source of FIG. 2.
FIGS. 4A-4B show timing diagrams for discussing effects of the embodiments.
FIG. 5 shows a simplified circuit diagram of a semiconductor switching assembly according to an embodiment including a supplementary circuit with a first auxiliary switch and a complementary voltage rail.
FIG. 6A shows a simplified circuit diagram of a semiconductor switching assembly according to an embodiment including a supplementary circuit with a first auxiliary switch and an energy storage element.
FIG. 6B shows a schematic timing diagram for the operation of the semiconductor switching assembly of FIG. 6A according to an embodiment.
FIG. 7 shows a simplified circuit diagram of a semiconductor switching assembly according to another embodiment including a supplementary circuit with a first auxiliary switch and an energy storage element.
FIG. 8 shows a simplified circuit diagram of a semiconductor switching assembly according to an embodiment concerning two first auxiliary switches in a half-bridge configuration, and schematic timing diagrams for discussing the operation of the semiconductor switching assembly.
FIG. 9 shows a simplified circuit diagram of a boost converter assembly with two parallel primary portions according to an embodiment and a schematic timing diagram for control signals of the boost converter assembly.
FIG. 10 shows a simplified circuit diagram of a boost converter assembly with two parallel semiconductor switches according to an embodiment and a schematic timing diagram for control signals of the boost converter assembly.
FIGS. 11A-11B show simplified circuit diagrams of boost converter assemblies according to other embodiments.
FIG. 12A shows a simplified circuit diagram of a single-switch gate driver circuit suitable for temporarily imposing a forward current through a diode structure according to an embodiment.
FIGS. 12B shows simplified timing diagrams for output signals of the single-switch gate driver circuit of FIG. 12A according to an embodiment.
FIG. 13 shows a simplified circuit diagram of a gate driver circuit suitable for temporarily imposing a forward current through a diode structure, and timing diagrams for output signals of the gate driver circuit according to an embodiment.

### DETAILED DESCRIPTION

In the following detailed description, reference is made to the accompanying drawings, which form a part hereof and in which are shown by way of illustrations specific embodiments in which a semiconductor switching assembly and a gate driver circuit may be practiced. It is to be understood that other embodiments may be utilized and structural or logical changes may be made without departing from the scope of the present disclosure. For example, features illustrated or described for one embodiment can be used on or in conjunction with other embodiments to yield yet a further embodiment. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive ohmic connection between electrically connected elements, for example a direct contact between the concerned elements or a low-resistive connection via a metal and/or heavily doped semiconductor material. The term "electrically coupled" includes that one or more intervening element(s) adapted for signal and/or power transmission may be connected between the electrically coupled elements, for example, elements that are controllable to temporarily provide a low-resistive connection in a first state and a high-resistive electric decoupling in a second state. An "ohmic contact" is a non-rectifying electrical junction with a linear or almost linear current-voltage characteristic.

Ranges given for physical dimensions include the boundary values. For example, a range for a parameter y from a to b reads as a ≤ y ≤ b. The same holds for ranges with one boundary value like "at most" and "at least".

The term "power semiconductor device" refers to semiconductor devices with a high voltage blocking capability of at least 30 V, for example 100 V, 600 V, 1.6 kV, 3.3 kV or more and with a nominal on-state current or forward current of at least 1 A, for example 10 A or more.

A semiconductor switching assembly may include a gate driver circuit. The gate driver circuit may be an integrated gate driver circuit. Alternatively, the gate driver circuit may include a gate driver logic circuit and further discrete and/or active elements for driving at least one output signal of the gate driver logic circuit.

The gate driver circuit may generate, output and drive a gate signal for a voltage controlled switching device. The voltage controlled switching device may be a power semiconductor device with insulated gate such as a MOSFET, an IGBT, in particular an RC-IGBT (reverse conducting IGBT), or an HEMT.

The gate signal may assume at least an active state and an inactive state. The gate signal may be a binary signal changing between two different voltage levels. When the gate signal is active (in the active state), the gate signal may have an on-level turning on the voltage controlled switching device. When the gate signal is inactive, the gate signal may have an off-level turning off the voltage controlled switching device.

For n-MOSFETs and n-IGBTs, the active gate signal may have a high level (high voltage level) and the inactive gate signal may have a low level (low voltage level). The high level may be in a range from +10V to +20V for Si-MOSFETs, in a range from +12V to +20V for Si-IGBTs, or in a range from +15V to +25V for SiC-MOSFETs, by way of example. The low level may be in a range from -1V to +1V. For example, the low level may be 0V or approximately 0V.

For p-MOSFETs and p-IGBTs, the active gate signal may have a low level and the inactive gate signal may have a high level. The high level may be in a range from -1V to +1V. For example, the high level may be 0V or approximately 0V. The low level may be in a range from -10V to -20V for Si-MOSFETs, in a range from -12V to -20V for Si-IGBTs, or in a range from -15V to - 25V for SiC-MOSFETs, by way of example.

The gate driver circuit may include a gate output terminal, a first transistor temporarily electrically connecting the gate output terminal through a first current limiting element with a reference terminal and a second transistor temporarily electrically connecting the gate output terminal through a second current limiting element with a supply voltage terminal. The gate driver circuit outputs the gate signal between the gate output terminal and the reference voltage terminal.

A diode structure may be electrically arranged between the gate output terminal and the reference voltage terminal. The diode structure may be placed such that a parasitic inductance effective between the diode structure and a gate input terminal of the voltage controlled switching device is smaller than the parasitic inductance effective between the gate output terminal of the gate driver circuit and the diode structure.

The diode structure is arranged to be reverse biased when the gate signal is active (has the on-level) and the voltage controlled switching device is on. The diode structure may be reverse biased when the gate signal has any voltage level with the same polarity as the on-level. The diode structure is forward biased when the gate signal has any voltage level with the opposite polarity of the on-level.

For voltage controlled switching devices with a positive gate threshold voltage, e.g. n-MOSFETs and n-IGBTs, the diode structure cathode is electrically connected to the gate input terminal of the voltage controlled switching device and the diode structure anode is electrically connected to that load terminal of the voltage controlled switching device, which is connected to the reference terminal of the gate driver circuit, e.g. the n-MOSFET source terminal or the n-IGBT emitter terminal. The diode structure is reverse biased for positive gate signal levels. The diode structure is forward biased for negative gate signal levels.

For voltage controlled switching devices with negative gate threshold voltage, e.g. p-MOSFETs and p-IGBTs, the diode structure anode is electrically connected to the gate input terminal of the voltage controlled switching device and the diode structure cathode is electrically connected to that load terminal of the voltage controlled switching device, which is connected to the reference terminal of the gate driver circuit, e.g. the p-MOSFET source terminal or the p-IGBT emitter terminal. The diode structure is reverse biased for negative gate signal levels. The diode structure is forward biased for positive gate signal levels.

The diode structure set-in voltage may be at most 3.5V, e.g., about 3V or less. The diode structure may include one single rectifying junction, which may be a pn junction or a Schottky contact. The diode structure may effectively reduce transient voltage spikes, which have a polarity opposite to the gate voltage on-level, at the gate input terminal of the voltage controlled switching device. As a consequence, the diode structure may contribute to reducing gate dielectric degradation in the voltage controlled switching device. The diode structure may have a positive effect on long-term gate threshold stability and may reduce a gate threshold voltage drift.

On the other hand, the presence of the diode structure may reduce the maximum voltage window between on-level and off-level, since the off-level may be limited to the set-in voltage of the diode structure. The presence of the diode structure may reduce a safety margin for unintentional turn on of the voltage controlled switching device.

For example, the voltage controlled switching device may be the low side switch in a half-bridge assembly. When the voltage controlled switching device is off and the high side switch turns on, the voltage across the two load terminals of the voltage controlled switching device may increase at a high rate such that a Miller current is able to pass through the Miller capacitance between the second load terminal and the gate input terminal of the voltage controlled switching element. The Miller current flows through the gate input terminal and may cause the effective gate voltage at the gate input terminal to increase to beyond the gate threshold voltage VGS(th).

Typically, an active Miller clamp may monitor the effective gate voltage at the gate input terminal and may temporarily connect the gate driver circuit gate output terminal with the reference potential if the gate voltage at the gate input terminal exceeds a predetermined level.

Instead of or in addition to an active Miller clamp, the semiconductor switching assembly may include a supplementary circuit that temporarily imposes an auxiliary current into the gate loop, wherein the auxiliary current passes the diode structure as forward current. The supplementary circuit may effect that the auxiliary current changes between at least two different current levels. The high current level may be selected according to device characteristics of the voltage controlled switching device, e.g., the maximum Miller current for steep positive voltage steps at the second load terminal. A low current level may be at most 10% of the high current level, for example 0µA or approximately 0µA. For convenience, the description of the following embodiments assumes that the supplementary circuit switches the auxiliary current on (imposes high current level) or off (imposes low current level).

The forward current flowing through the diode structure can partially commutate into the voltage controlled switching device as needed, e.g. at the end of a reverse conducting operation mode of the voltage controlled switching device. In this context, commutation refers to the process by which a current flow passes from one branch to another. The reverse conducting operation mode may be the reverse conducting mode of an RC-IGBT or the conducting mode of an MOSFET body diode. In a half-bride configuration, the reverse conducting mode may end, when the voltage controlled switching device is off and the other switch of the half-bridge turns on.

Since the auxiliary current through the diode structure may magnetize the parasitic inductance in the gate loop of the voltage controlled switching device prior to commutation, and due to the short connection between diode structure and voltage controlled switching device, commutation from the diode structure to the voltage controlled semiconductor device is not or only to a low degree impeded by a parasitic inductance and a parasitic resistance. Displacement currents in the voltage controlled switching device do not or only to a low degree affect the effective gate voltage at the gate input terminal of the voltage controlled switching device.

The supplementary circuit may switch on the auxiliary current through the diode structure prior to a fast positive voltage slope at the second load terminal, e.g. prior to or during a reverse conducting operation mode, and may maintain the current flow up to a predetermined time after completion of the reverse conducting operation. The supplementary circuit may switch off the auxiliary current through the diode structure prior to the voltage controlled switching device turning on until after the voltage controlled switching device has been turned off.

Other than an active Miller clamp, the supplementary circuit does not temporarily short-circuit the gate output terminal and the reference voltage terminal. Further in contrast to an active Miller clamp, it is not required to monitor the current voltage at the gate input terminal of the voltage controlled switching device in the off-state.

According to an embodiment the semiconductor switching assembly may include a voltage controlled switching device with a gate input terminal, a first load terminal and a second load terminal. The first load terminal may be electrically connected to the reference voltage terminal.

The gate input terminal may be electrically coupled to the gate output terminal of the gate driver circuit. For example, the gate input terminal and the gate output terminal may be directly electrically connected through a direct conductive path formed on a substrate and/or through one or more bond wires, such that only the parasitic resistance and the parasitic inductance of the direct conductive path are effective between the gate output terminal and the gate input terminal.

Alternatively, a series gate resistor may be electrically connected between the gate output terminal and the gate input terminal. The gate output terminal of the gate driver circuit and a first terminal of the series gate resistor may be electrically connected. A second terminal of the series gate resistor and the gate input terminal of the voltage controlled switching device may be electrically connected. The series gate resistor may shape the slopes of the gate signal and may have an electrical resistance in a range from 0.5Ω to 1kΩ, e.g. from 1Ω to 100Ω. The voltage effective at the gate input terminal controls a load current between the first and the second load terminal.

The voltage controlled switching device may be conducting in a reverse-biased state. For example, the voltage controlled switching device may be an MOSFET with body diode or an RC-IGBT.

The diode structure may be formed outside the voltage controlled switching device, wherein the diode structure may be formed directly at or in close vicinity to the gate input terminal and the first load terminal of the voltage controlled switching device. In presence of a series gate resistor, the diode structure may be electrically connected with the second terminal of the series gate resistor and with the gate input terminal of the voltage controlled switching device. In the absence of a series gate resistor, the diode structure may be placed such that a greater portion of a total parasitic inductance between the gate output terminal and the gate input terminal is effective between the gate output terminal of the gate driver and the diode structure and such that a smaller portion of the total parasitic inductance between the gate output terminal and the gate input terminal is effective between the diode structure and the gate input terminal of the voltage controlled switching device.

The semiconductor switching assembly may be or may include a power module with at least one set of two or more voltage controlled switching devices electrically connected in parallel and mounted on a ceramic substrate or printed circuit board. The power module may include two sets of voltage controlled switching devices arranged in a half bridge configuration. The power module may include a gate driver circuit and may include at least one freewheeling diode for each set of voltage controlled switching devices.

The gate driver circuit gate output terminal and the voltage controlled switching device gate input terminal may be directly electrically connected. Alternatively, one or more electronic elements may be electrically connected between the gate output terminal and the gate input terminal. The electronic elements between the gate output terminal and the gate input terminal may include a gate series resistor. The connection between the gate output terminal and the gate input terminal may include a parasitic inductance. The parasitic inductance may include the inductance of a gate lead, and/or the inductance of a bond wire between the gate lead and a gate pad of the voltage controlled switching device and/or the inductance of a conductive path formed on a printed circuit board or on a ceramic substrate.

Providing the diode structure in close vicinity to the voltage controlled switching device may contribute to improving the suppression of transient overshoots at the gate input terminal and may supersede the necessity for providing individual solutions for suppressing gate voltage overshoots in differently configured power modules.

According to an embodiment the supplementary circuit may impose the forward current through the diode structure prior to and during a transition from a low voltage to a high voltage between the second load terminal and the first load terminal. The low voltage may have a first polarity and the high voltage may have a second polarity. The transition from the low voltage to the high voltage may coincide with the start of a reverse recovery of a reverse conducting element in the voltage controlled switching device, e.g., the body diode of an MOSFET or the reverse diode of an RC-IGBT and/or with the start of a reverse recovery of an anti-parallel freewheeling diode connected to the first and second load terminals.

For example, in case the voltage controlled switching device is the low side switch or the high side switch in a half-bridge, the supplementary circuit may impose the forward current through the diode structure prior to and during a transition from the off-state to the on-state of the opposite switch in the half-bridge.

According to an embodiment one single semiconductor device may include both the diode structure and the voltage controlled switching device. In other words, the diode structure and the voltage controlled switching device may share a common device package and a common semiconductor body. Semiconducting portions of the diode structure and the voltage controlled switching device may be monolithically integrated in the same semiconductor body. The semiconductor body may include both at least one doped region of the diode structure and a source/emitter region of the voltage controlled switching device.

For example, the voltage controlled switching device may be an n-MOSFET including a source region, wherein the source region, the anode region of the diode structure and the first load terminal are directly electrically connected. According to another example, the voltage controlled switching device is an n-channel RC-IGBT including an emitter region, wherein the emitter region, the anode region of the diode structure and the first load terminal are electrically connected.

According to an embodiment the supplementary circuit may include a controllable current source. A switchable current path of the current source may be electrically connected between the gate output terminal and the reference voltage terminal. Alternatively, the switchable current path may be electrically connected between the gate output terminal and a complementary voltage rail. A voltage between the complementary voltage rail and the reference voltage terminal may have a polarity opposite to the polarity of the gate threshold voltage. In other words, the voltage of the complementary voltage rail may have the opposite polarity of the active gate signal.

For a voltage controlled switching device with positive gate threshold voltage, the switchable current path may be electrically connected between the gate output terminal and a negative voltage rail.

The controllable current source is electrically connected between the gate input terminal and the first load electrode of the voltage controlled switching device. In an on-state of the controllable current source, the controllable current source may impose an auxiliary current through the switchable current path. The auxiliary current supplied by the controllable current source is equal to the forward current through the diode structure. In an off-state, the controllable current source may impose no current or a current, which is significantly lower than the auxiliary current in the switchable current path.

According to an embodiment the supplementary circuit may include a first auxiliary switch and a passive element. The first auxiliary switch and the passive element are electrically arranged in series between the gate output terminal and a complementary voltage rail. The complementary voltage rail supplies a voltage with a polarity opposite to the polarity of the active gate signal.

The passive element may include at least one of an ohmic resistor element and an inductor element. The complementary voltage rail may continuously supply a voltage with the opposite polarity of the gate threshold voltage or may supply a voltage with the opposite polarity of the gate threshold voltage only temporarily.

According to another embodiment the supplementary circuit may include a first auxiliary switch and an energy storage element. The first auxiliary switch and the energy storing element may be arranged such that the first auxiliary switch temporarily connects the energy storing element in series between the gate output terminal and the reference voltage terminal.

The energy storing element may be electrically connectable to and disconnectable from a network node capable of supplying electric energy to the energy storing element. The energy storing element may include an inductor.

According to an embodiment the supplementary circuit may include a first auxiliary switch and an inductor. The first auxiliary switch and the inductor may be electrically arranged in series between the gate output terminal and the reference voltage terminal. The inductor may be temporarily electrically connectable to a supply voltage rail supplied with a supply voltage. The supply voltage may have the same polarity with respect to the reference voltage terminal as the gate threshold voltage and the active gate signal.

The inductor may be a choke. An inductance of the inductor may be in a range from 0.5µH to 300µH, e.g., from 1µH to 200µH. For voltage-controlled semiconductor devices with positive gate threshold voltages such as n-MOSFETs and n-IGBTs, the supply voltage may be positive. A decoupling diode may be electrically arranged in series to the first auxiliary switch between the gate driver output and the inductor.

According to an embodiment a gate driver device may include both the gate driver circuit and a control circuit of the supplementary circuit. In other words, the gate driver circuit and the control circuit of the supplementary circuit may be integrated in the same gate driver package.

The control circuit of the supplementary circuit may generate a control signal for the controllable current source or for the first auxiliary switch. The control circuit may control the charging and discharging of the energy storage element.

The control circuit of the supplementary circuit and the gate driver circuit may be monolithically integrated in and/or on the same semiconductor body. For example, the gate driver circuit may include a logic/driver circuit that integrates the logic circuits and drive transistors of the control circuit and the gate driver circuit. The gate driver package may include further elements of the supplementary circuit, e.g., the first auxiliary switch, the second auxiliary switch, the decoupling diode, and/or the storage element.

Another embodiment refers to a half-bridge gate driver device. The half-bridge gate driver device may include a gate signal circuit and at least one control circuit.

The gate signal circuit may include a first gate signal circuit portion and a second gate signal circuit portion. The first gate signal circuit portion may generate and drive a first gate signal for a first voltage controlled switching device. The first gate signal may be output at a first gate driver output of the half-bridge gate driver circuit. The second gate signal circuit portion may generate and drive a second gate signal for a second voltage controlled switching device. The second gate signal may be output at a second gate driver output of the half-bridge gate driver circuit. The first gate signal is inactive at least when the second gate signal is active. The second gate signal is inactive at least when the first gate signal is active. The first gate signal and the second gate signal are alternatingly active, wherein at each point in time at most one the first and second gate signals is active. In some of the embodiments, the first gate signal and the second gate signal may be strictly alternatingly active, wherein each active period of the first gate signals follows an active period of the second gate signal and vice versa. Idle periods may separate phases of an active first gate signal and phases of an active second gate signal.

The control circuit may include a first control output node and may generate a first control signal at the first control output node. The first control signal may become active after a transition of the first gate signal from active to inactive and prior to a transition of the second gate signal from inactive to active. The first control signal may become inactive after the transition of the second gate signal from inactive to active and prior to or with a transition of the first gate signal from inactive to active. For example, the first control signal may be exclusively synchronized to the start and end of the inactive period of the first gate signal.

For n-MOSFETs and n-IGBTs, an active first gate signal and/or an active first control signal may have a high level (e.g., +5V, +10V, +12V, +15V, +18V) and an inactive control signal may have a low level (e.g. 0V, -5V, -10V, -12V, -15V, -18V). According to an embodiment the control output node of the internal control circuit may directly electrically connected to a first control terminal of the gate driver device. A first auxiliary switch of a supplementary circuit as described above may be provided outside the gate driver circuit.

According to another embodiment the gate driver circuit may include the first auxiliary switch. The first control output node may be electrically connected to a gate input node of the first auxiliary switch and one of the load terminal nodes of the first auxiliary switch may be electrically connected to the control terminal of the gate driver circuit. The other one of the load terminal nodes of the first auxiliary switch may be electrically connected or electrically coupled to the first gate driver output.

Another embodiment concerns a single-switch gate driver device. The single-switch gate driver device may include a single-switch gate driver circuit and a single-switch control circuit. The single-switch gate driver circuit may be adapted to drive a gate signal for a voltage controlled switching device. The single-switch control circuit may include a first control output node and may generate a first single-switch control signal at the first control output node. The first single-switch control signal may become active with or after a transition of the gate signal from active to inactive. The first single-switch control signal may become inactive with or prior to a subsequent transition of the gate signal from inactive to active.

Within an inactive period of the gate signal, the first single-switch control signal may be synchronized with respect to a trailing edge or falling edge of a further gate signal that controls another semiconductor switch. Alternatively, the first single-switch control signal may be exclusively synchronized to the start and end of the inactive period of the gate signal.

For example, a transition of the first single-switch control signal from inactive to active may be directly triggered by a transition of the gate signal from active to inactive, wherein the transitions may occur contemporaneously or wherein the transition of the first single-switch control signal directly follows the transition of the gate signal. Alternatively, the transition of the first single-switch control signal may be delayed in time and follows the transition of the gate signal only after a first dead time.

A transition of the first single-switch control signal from active to inactive may precede or may be directly triggered by a transition of the gate signal from inactive to active, wherein the transitions may occur contemporaneously or wherein the transition of the first single-switch control signal directly precedes the transition of the gate signal. Alternatively, the transition of the gate signal may be delayed in time and follows the transition of the first single-switch control signal after a second dead time.

The single-switch gate driver device may be used to control a semiconductor switch in a single-ended switching circuit, such as a chopper circuit (German: Zerhacker-Schaltkreis). The chopper circuit may be a boost converter (German: Hochsetzsteller), a buck converter (German: Tiefsetzsteller), or a buck/boost converter (German: Tief/Hochsetzsteller). The single-switch control signal may be used to temporarily impose an auxiliary current through a diode structure which is effective between gate terminal and source/emitter terminal of the semiconductor switch and which is reverse biased when the semiconductor switch is on.

The auxiliary current passes the diode structure as forward current and may directly commutate into the semiconductor switch when a voltage across the load terminals of the semiconductor switches increases at a high rate, e.g., when another semiconductor switch in the single-ended switching circuit turns on or turns off and charges the internal Miller capacity. The internal commutation avoids a temporary rise of the effective gate voltage. In this way, the described combination of the single-switch gate driver device with a controllable current source and a diode structure reduces the risk for unintentional turn on of the semiconductor switch, in particular in single-ended switching circuits with two or more semiconductor switches electrically arranged in parallel and switching at different points in time.

According to an embodiment, the single-switch gate driver may include a first single-switch control terminal and a first auxiliary switch, wherein the first control output node is electrically connected to a gate input node of the first auxiliary switch and wherein one of the load terminal nodes of the first auxiliary switch is electrically connected to the first single-switch control terminal.

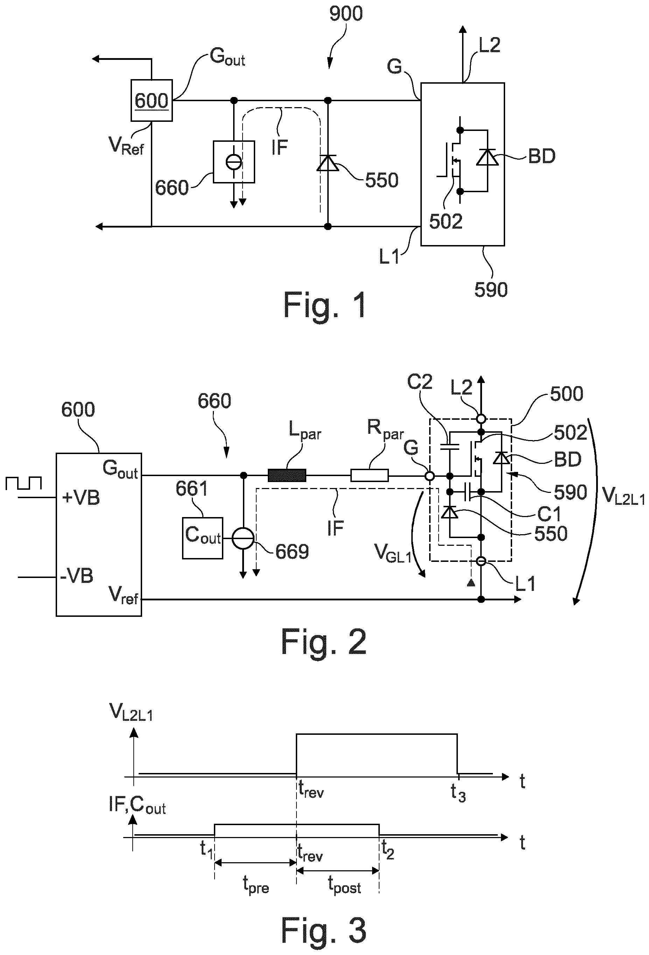

FIG.1 shows a semiconductor switching assembly 900 including a gate driver circuit 600 that generates and outputs a gate signal for a voltage controlled switching device 590 with n-channel field effect transistor cells 502, internal body diode BD, gate input terminal G, first load terminal L1 and second load terminal L2. The gate driver circuit 600 outputs the gate signal between gate output terminal Gout and reference terminal Vref. The gate driver circuit gate output terminal (gate driver output) Gout and the gate input terminal G of the voltage controlled switching device (gate input G) are electrically connected. The gate driver circuit reference terminal Vref and the first load terminal L1 of the voltage controlled switching device are electrically connected.

A diode structure 550 is electrically arranged between the gate input G and the first load terminal L1. The diode structure 550 clamps negative transient undershoots at the gate input terminal G. Negative undershoots may be the result of device-internal displacement currents in the voltage controlled switching device 590.

For example, in an off-state of the voltage controlled switching device 590 a sudden release of previously stored energy in the load current path of the voltage controlled switching device 590, either inductive or capacitive, may result in a high negative voltage transient at the second load terminal L2. A voltage transient with negative dV/dt at the second load terminal L2 may result in an instantaneous current flow through the internal body diode from the first load terminal L1 to the second load terminal L2. The internal current flow discharges a device-internal capacitance and may result in a short negative voltage spike across the gate-to-source capacitance.

When the negative voltage across the gate-to-source capacitance falls below the negative set-in voltage of the diode structure 550, the diode structure 550 becomes conductive and cuts off more negative voltage spikes. The diode structure 550 therefore limits the negative voltage at the gate input terminal G and across a gate dielectric of the transistor cells 502 to a value given by the set-in voltage of the diode structure 550.

The set-in voltage of the diode structure 550 also limits the gate off-voltage, which can be supplied by the gate driver circuit 600. For example, the gate off-voltage is typically 0V or approximately 0V. Small positive voltage glitches at the gate input terminal G may result in an unintentional turn-on of the voltage controlled switching device 590.

A supplementary circuit 660 temporarily imposes an auxiliary current IF, which flows through the diode structure 550 in forward direction. The forward current of the diode structure 550 can partially commutate into the voltage controlled switching device 590 as needed and may compensate the effect of internal displacement currents that cause positive voltage spikes. An example is given by reference to FIG. 2 and FIG. 3.

In FIG. 2 a semiconductor device 500 includes the diode structure 550 and the voltage controlled switching device 590 of FIG. 1. An anode of the internal body diode BD is electrically connected to the first load terminal L1. A cathode of the internal body diode BD is electrically connected to the second load terminal L2. A parasitic first capacitance C1 is effective between the gate input terminal G and the first load terminal L1. A parasitic Miller capacitance C2 is effective between the gate input terminal G and the second load terminal L2.

A connection between gate driver output Gout and the gate input G may include a parasitic resistance Rpar and/or a parasitic inductance Lpar. In addition, a series gate resistor may be electrically connected between the gate driver output Gout and the gate input G The diode structure 550 may be arranged such that the greater part of Rpar and Lpar is effective between the gate driver output Gout and the diode structure 550 and only a smaller or marginal part of Rpar and Lpar is effective between the diode structure 550 and the transistor cells TC. In case the gate loop includes a series gate resistor, the diode structure 550 may be connected to a network node between the series gate resistor and the gate input terminal G.

The supplementary circuit 660 includes a controllable current source 669 and a control circuit 661. The controllable current source 669 may be connected to the gate driver output Gout such that a greater part of Rpar and Lpar may be effective between the controllable current source 669 and the gate input terminal G and a smaller part of Rpar and Lpar may be effective between the gate driver output Gout and the controllable current source 669.

The controllable current source 669 may change between an on-state and an off-state. In the on-state, the controllable current source 669 imposes an auxiliary current IF through a switchable current path that includes the diode structure 550 and the controllable current source 669. The auxiliary current IF may be at least equal to 50% of a maximum Miller current through the Miller capacitance C2 or may be at least equal to the maximum Miller current. In the off-state, the controllable current source 669 imposes no current or a current, which is significantly lower than the auxiliary current IF.

A control output terminal Cout of the control circuit 661 is electrically connected with a control input terminal of the controllable current source 669. The control circuit 661 generates a control signal for the controllable current source 669. The control signal may alternatingly have an active level turning on the controllable current source 669 and an inactive level turning off the controllable current source 669.

As shown in FIG. 3, control of the controllable current source 669 may be synchronized with a fast rising voltage slope of VL2L1 at t=trev. The controllable current source 669 may switch on the auxiliary current IF at t=t1 prior to trev. A lead time tpre between t1 and trev may be at least 100ns and at most 1µs. The controllable current source 669 may be switched off at t=t2 prior to or with the next trailing voltage slope of VL2L1 at t=t3. A follow-up time tpost between trev and t2 may depend on the voltage class and may be at least 50ns and at most 2µs.

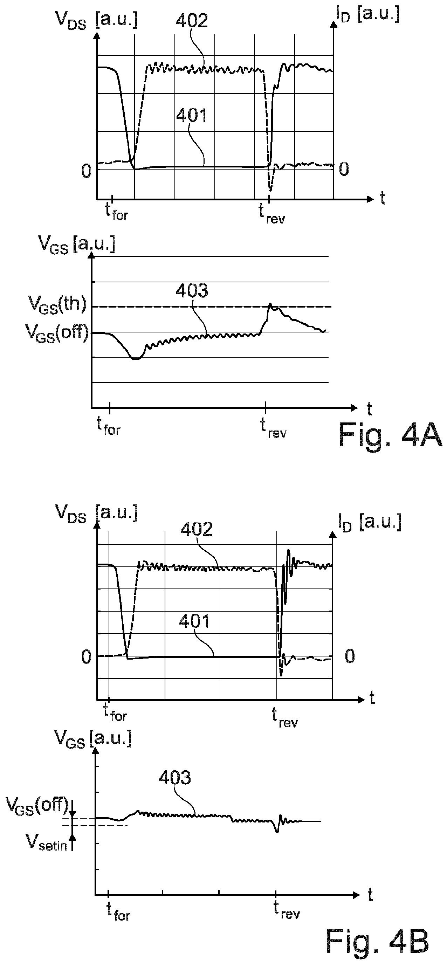

The timing diagrams in FIGS. 4A and 4B show the effects of diode structure 550 and supplementary circuit 660 of FIG. 1, FIG. 2 and FIG. 3 with reference to an n-MOSFET as the voltage controlled switching device 590. Line 401 shows the time-dependent drain-to-source voltage VDS, line 402 the time-dependent drain current ID and line 403 the time behavior of the effective gate-to-source voltage VGS directly at the gate input of the voltage controlled switching device. During the illustrated period of time, the gate driver circuit drives the off-voltage VGS(off).

FIG. 4A shows timing diagrams for VGS and VDS for a reference example without the diode structure 550 and without the supplementary circuit 660 of FIGS. 1 to 2 for VGS (off) = 0V. FIG. 4B shows the timing diagrams for VGS and VDS for the voltage-controlled switching device 590 of FIGS. 1 to 2 for VGS(off) = 0V.

During the off-state of the voltage controlled switching device 590 a rapid decrease of VDS 401 at t=tfor forces a Miller current to pass through the Miller capacitance. This may be the case in resonant power supplies and inverter circuits during freewheeling and synchronous rectification operation. For example, in a half-bridge configuration the body diode of the low-side switch starts to conduct when the high-side switch turns off the load current through an inductive load connected to the common switching node. The transient Miller current through the Miller capacitance causes the effective gate voltage VGS at the gate input terminal to transiently drop significantly to below VGS(off).

The resulting negative voltage transient at tfor as shown in FIG. 4A may significantly contribute to degradation of the gate dielectric in the voltage controlled switching device 590.

As shown in FIG. 4B the diode structure 550 clamps a negative voltage at the gate input G to the set-in voltage of the diode structure 550, e.g., to -3V, -2V or less negative and reduces gate dielectric deterioration.

A rapid increase of VDS 401 at t=trev forces a transient Miller current to pass through the Miller capacitance into the inverse direction as in case of a rapid decrease. For example, in a half-bridge configuration the body diode of the first switch stops to conduct when the other switch turns on a current flow through the inductive load connected to the common switching node. The transient Miller current causes the effective gate voltage VGS at the gate input terminal to transiently increase significantly. The transient Miller current may transiently increase the effective gate-to-source voltage VGS to beyond the gate threshold voltage VGS(th) as illustrated in FIG. 4A and may cause an unintended turn on of the voltage controlled switching device.

The supplementary circuit temporarily imposes an auxiliary current, which is effective as forward current through the diode structure, prior to t=trev. The forward current is selected to be at least half of the maximum Miller current, or at least the maximum Miller current. The forward current flowing through the diode structure can partially directly commutate into the voltage controlled switching device at t=trev and may suppress an increase of the effective gate-to-source voltage to beyond the gate threshold voltage VG(th) thereby preventing unintended turn on of the voltage controlled switching device.

The auxiliary current pre-magnetizes the parasitic inductance in the gate loop prior to the body diode reverse recovery. In combination with the short connection between the diode structure and the voltage controlled switching device, the commutation current is not or only to a low degree adversely affected by parasitic inductances and/or parasitic resistances.

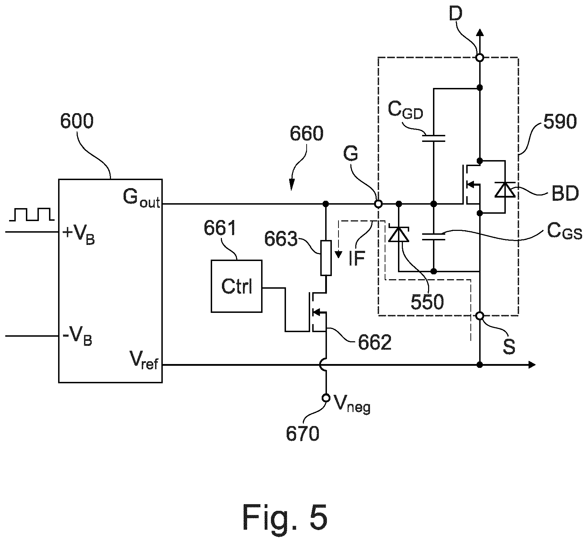

In FIG. 5 the voltage controlled switching device 590 is an n-MOSFET with internal body diode BD, wherein an n-MOSFET drain terminal D represents the second load terminal and wherein an n-MOSFET source terminal S represents the first load terminal. An anode of the internal body diode BD is electrically connected to the source terminal S. A cathode of the internal body diode BD is electrically connected to the drain terminal D. A parasitic gate-to-source capacitance CGS is effective between the gate input terminal G and the source terminal S. A parasitic gate-to-drain capacitance CGD forms the Miller capacitance effective between the gate input terminal G and the drain terminal D. The diode structure 550 may be or may include a Schottky contact.

The supplementary circuit 660 includes a first auxiliary switch 662 and a resistor element 663. The first auxiliary switch 662 and the resistor element 663 are electrically arranged in series between the gate driver output Gout and a complementary voltage rail 670. The control output Cout of the control circuit 661 is connected to the gate of the first auxiliary switch 662. The complementary voltage rail 670 has a negative polarity and may have a potential of -5V, by way of example.

Turning on the voltage-controlled switching element 662 imposes an auxiliary current IF through the diode structure 550 and the resistor element 663. The resistance of the resistor element 663 is selected such that the auxiliary current IF may be at least as high as the maximum Miller current in the voltage controlled switching device 590 during reverse recovery of the body diode BD. For example, the auxiliary current IF may in a range from 10% to 500% of the gate current in the respective application.

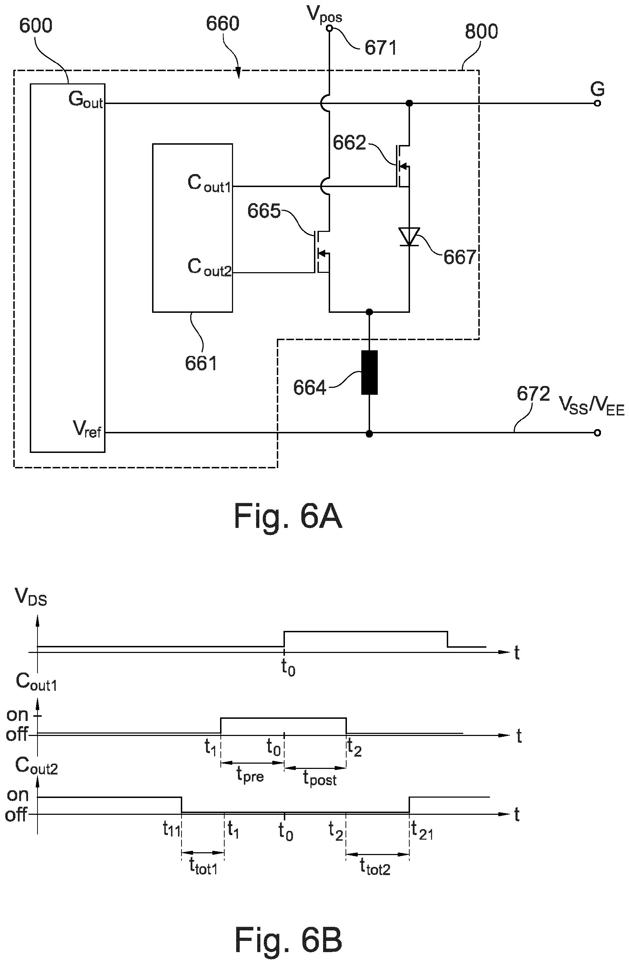

FIGS. 6A shows a supplementary circuit 660 including an inductor 664. The inductor 664, a decoupling diode 667 and a first auxiliary switch 661 are electrically connected in series between a gate driver output Gout and the reference potential rail 672. The decoupling diode 667 may be electrically arranged between the inductor 664 and the controlled switching element 661, wherein a cathode of the decoupling diode 667 is oriented to the reference potential rail 672 and to the inductor 664.

In addition, the inductor 664 and a second auxiliary switch 665 are electrically connected in series between a positive supply voltage rail 671 and the reference potential rail 672. A first control output Cout1 of a control circuit 661 controls the first auxiliary switch 662. A second control output Cout2 of the control circuit 661 controls the second auxiliary switch 665. During a charging phase, the inductor 664 is charged from the positive supply voltage rail 671 through the second auxiliary switch 665. The decoupling diode 667 prevents a current to flow from the positive supply voltage rail 671 to the gate loop during the charging phase. During a discharging phase, the inductor 664 discharges through the first auxiliary switch 662 thereby imposing the auxiliary current through the diode structure.

A gate driver device 800 may integrate the gated driver circuit 600 and at least parts of the supplementary circuit 660. For example, in addition to a gate logic circuit and a gate driver stage, the gate driver device 800 may integrate the control circuit 661. In addition to the control circuit 661, the first auxiliary switch 662, the second auxiliary switch 665 and/or the decoupling diode 667 may be integrated in the gate driver circuit 600.

As illustrated in FIG. 6B the output signal of the second control output Cout2 may turn on the second auxiliary switch 665 for a predetermined period of time. A charge current through the second auxiliary switch 665 and the inductor 664 charges the inductor 664 that stores energy in a magnet field. At t=t11 the second auxiliary switch 665 disconnects the charged inductor 664 from the positive voltage rail 671. After a first idle time ttot1 the first auxiliary switch 662 connects the inductor 664 to the gate input G. The inductor 664 imposes an auxiliary current through the diode structure 550 (illustrated in FIG. 1 and FIG. 2).

When after the lead time tpre (see FIG. 3) the drain-to-source voltage VDS rises at t=t0, the auxiliary current may at least partly commutate into the semiconductor device 500 illustrated in FIG. 1 and FIG. 2. After the follow-up time tpost the first auxiliary switch 662 disconnects the inductor 664 from the gate loop at t=t2. After a second idle time ttot2 the second auxiliary switch 665 may connect the charged inductor 664 to the positive voltage rail 671 at t=t21.

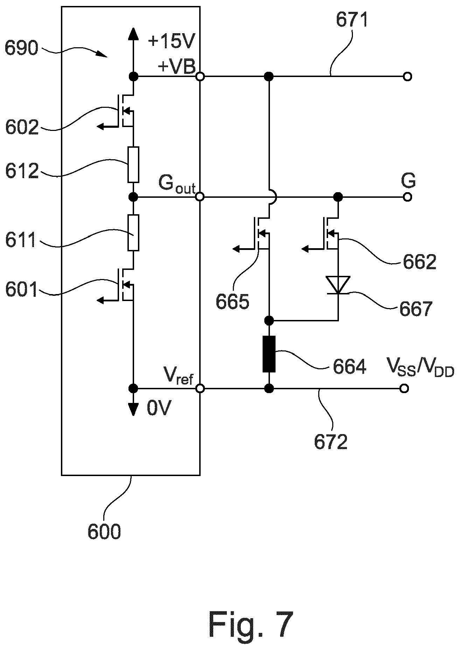

FIG. 7 shows a gate driver circuit 600 including a gate driver stage 690. Alternatingly, a first transistor 601 connects the gate driver output Gout through a first current limiting element 611 to a reference voltage terminal Vref and a second transistor 602 connects the gate driver output Gout through a second current limiting element 612 to a positive supply terminal +VB. The reference voltage terminal Vref is connected to a reference supply rail 672 with a potential of 0V. The positive supply terminal +VB is connected to a positive supply voltage rail 671 supplying a voltage of, e.g., +15V or +18V. The second auxiliary switch 665 temporarily connects the inductor 664 to the positive supply voltage rail 671 and the positive supply terminal +VB.

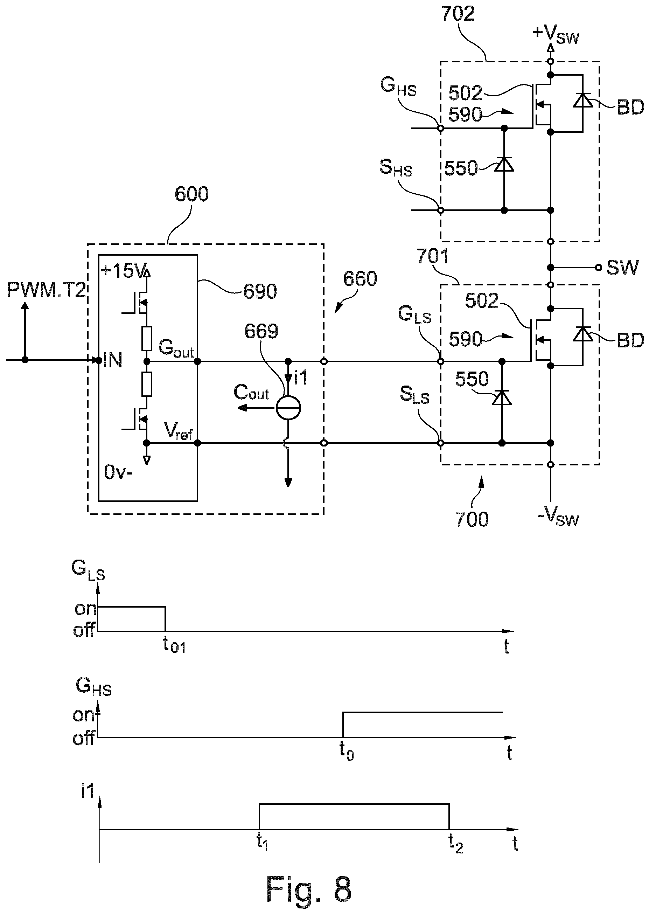

In FIG. 8 a half-bridge assembly 700 includes a low-side switch 701 and a high-side switch 702. The load path of the high-side switch 702 may be between a positive load voltage rail +VSW and a switching node SW. The load path of the low-side switch 701 may be between the switching node SW and a negative load voltage rail -VSW. The negative load voltage rail -VSW and a reference voltage rail 672 may be electrically connected. A gate output terminal Gout of a gate driver circuit 600 may be electrically connected with the low-side switch gate input GLS. A supplementary circuit 660 according to any of the above-described embodiments is provided in the gate loop of the low-side switch 701. The set-up for the high-side switch 702 and the set-up for the low-side switch 701 may be the substantially the same.

Individual gate driver circuits may be provided for the low-side switch 701 and the high-side switch 702. Alternatively, one single half-bridge gate driver circuit may integrate both gate driver circuits 600.

The controllable current source 669 for the low-side switch 701 turns on during the off-state of the low-side switch 701 at t=t1 prior to that the high-side switch turns on. The controllable current source 669 for the low-side switch 701 turns off during the off-state of the low-side switch 701 at t=t2 after that the high-side switch has turned on and prior to that the high-side switch turns off

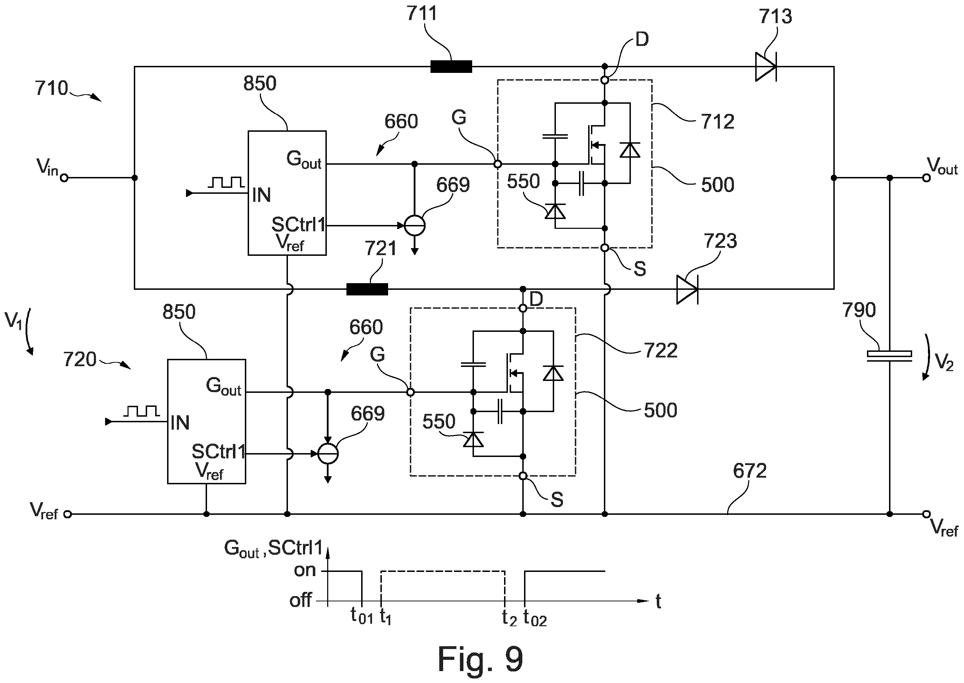

FIG. 9 shows a boost converter with two primary stages 710, 720. The boost converter may include more than the two illustrated primary stages 710, 720. Each primary stage 710, 720 includes a boost inductor 711, 721, a boost diode 713, 723, and a boost switch 712, 722. In each primary stage 710, 720 the boost inductor 711, 721 is electrically connected to an input voltage terminal Vin of the boost converter. The anode of the boost diode 713, 723 is electrically connected to the boost inductor 711, 721. The cathode of the boost diode 713, 723 is electrically connected to a smoothing capacitor 790 and to an output terminal Vout of the boost converter. The load path of the boost switch 712, 722 is electrically connected between the anode of the boost diode 713, 723 and a reference voltage rail 672.

When in one of the primary stages 710, 720 the respective boost switch 712, 722 is closed, the input voltage V1 supplies a current that flows through the boost inductor 711, 721 and the boost inductor 711, 712 stores energy in a magnetic field. When the boost switch 712, 722 opens, the magnetic field maintains the current through the boost inductor 712, 722 towards the smoothing capacitor 790 and the load. The polarity of the voltage across the boost inductor 711, 712 reverses and the voltage across the boost inductor 711, 712 adds to the supply voltage Vin. The voltage dropping across the open boost switch 712, 722 is supplied through the boost diodes 713, 723 to the smoothing capacitor 790. As long as the boost switch 712, 722 is cycled fast enough, the boost inductor 711, 721 will not discharge fully in between charging stages, and the output voltage V2 across the smoothing capacitor 790 is always greater than the input voltage V1. The boost diodes 713, 723 prevent the smoothing capacitor 790 from discharging through the closed boost switches 712, 722.

In full load operation, the first primary stage 710 and the second primary stage 720 may operate in parallel, wherein both boost switches 712, 722 turn on at the same time and turn off at the same time. Under partial load, supplying the output voltage V2 through one single primary stage 710, 720 may reduce switching losses and may be more efficient in terms of overall power loss.

Each boost switch 712, 722 may be or may include a semiconductor device 500 with voltage controlled switching devices 590 as described with reference to the previous figures. Each semiconductor device 500 may include a diode structure 550 electrically arranged between the gate input terminal G and the source terminal S. The diode structure 550 is reverse biased when the semiconductor device 500 is on. A supplementary circuit 660 includes a controllable current source 669. A single-switch gate driver device 850 outputs a first single-switch control signal at a first single-switch control terminal SCtrl1. The first single-switch control signal controls the controllable current source 669. At a gate driver output Gout the single-switch gate driver device 850 outputs a gate output signal that turns off the semiconductor device 500 at t = t01.

The first single-switch control signal output at SCtrl1 may turn on the controllable current source 669 at t = t1 at the beginning of the off state of the semiconductor device 500. In the on-state of the controllable current source 669, the controllable current source 669 imposes an auxiliary current in a portion of the gate loop of the semiconductor device 500 such that a forward current flows through the diode structure 550.

Turn-on and turn-off of the semiconductor device 500 in the parallel primary stage 710, 720, abrupt change of load and/or electromagnetic coupling form neighboring switches may generate fast and pronounced transient voltage peaks across the load terminals of the semiconductor device 500. The forward current through the diode structure 550 may directly commutate within the semiconductor device 500, may compensate internal displacement currents and may suppress unintentional turn on of the semiconductor device 500 in the idle one of the primary stages 710, 720, e.g., in a partial load operating mode of the boost converter.

The first single-switch control signal output at SCtrl1 may turn off the controllable current source 669 at t = t2 prior to or at the end of the off state of the semiconductor device 500 at t = t02.

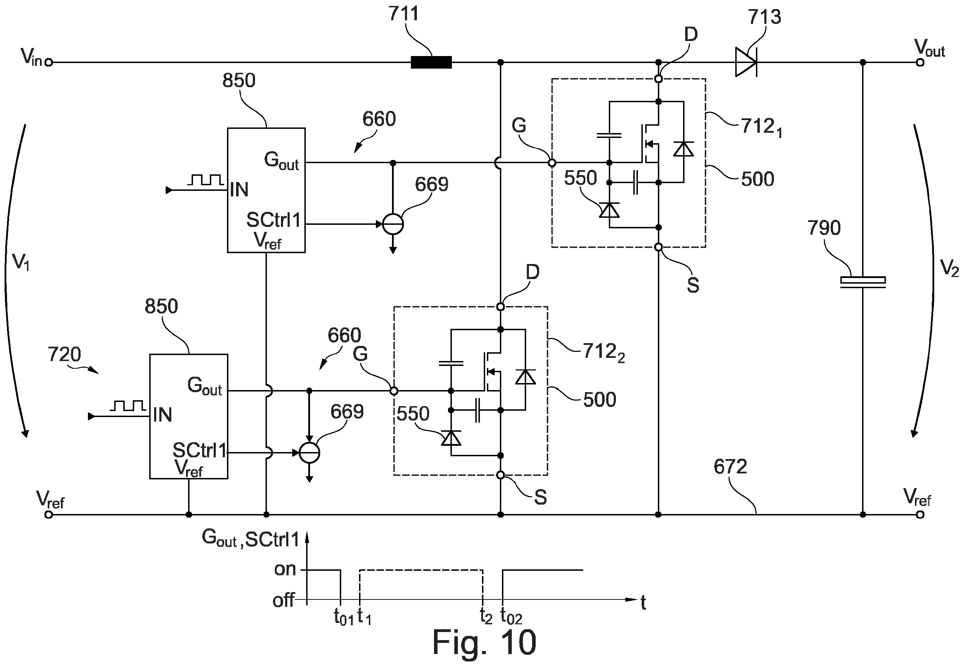

In FIG. 10 two semiconductor devices 500 are electrically connected in parallel in the same primary stage 710. The semiconductor devices 500 may operate synchronously, e.g., under full load condition. Under certain operation conditions, only one of the semiconductor devices 500 changes between open and closed while the other one remains open. The combination of a suitable single-switch gate driver device 850, controllable current source 669 and diode structure 550 as described above may reduce the risk of unintentional turn on of the idle one of the semiconductor devices 500.

Equivalent considerations as described with respect to FIGS. 9 and 10 may apply for other types of single-ended switching circuits, like chopper circuits, e.g. a buck converter or a buck/boost converter.

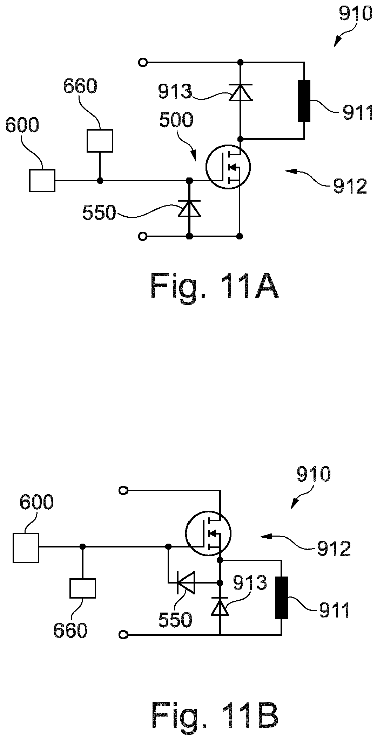

FIGS. 11A and 11B show single-ended switching circuits 910 with inductive load 911, switching assembly 912 and freewheeling diode 913. In each of the single-ended switching circuits 910 the switching assembly 912 may include a semiconductor device 500, a diode structure 550, a gate driver circuit 600 and a supplementary circuit 660 as described with reference to any of the preceding figures to prevent unintentional turn on. In particular, each single-ended switching circuit 910 may include two or more switching assemblies 910 with the load paths electrically connected in parallel to each other.

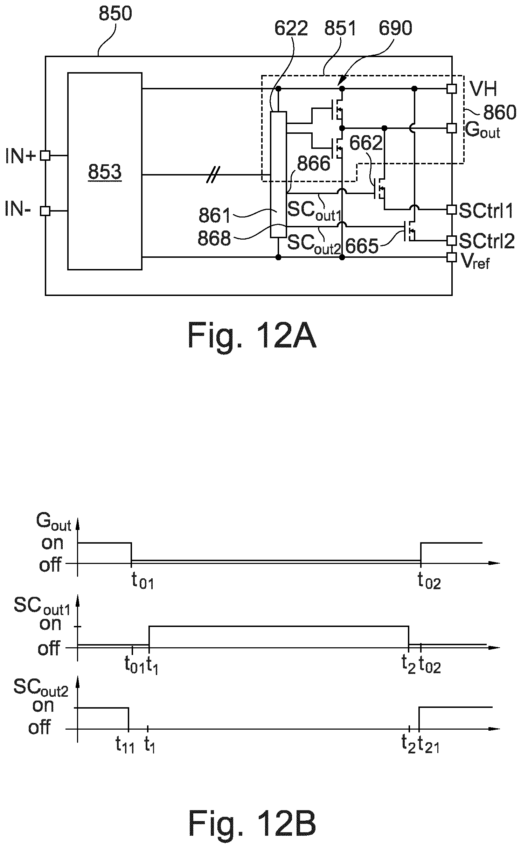

FIG. 12A shows a single-switch gate driver device 850 that includes an input portion 853 and a gate driver portion 851. The input portion 853 receives an input signal at input terminals In+, In-. The input signal may include square pulses and may be received from a pulse width modulator circuit. The input portion 853 may pre-process the input signal and may transfer the pre-processed input signal to the gate driver portion 851.

The gate driver portion 851 includes a gate signal circuit portion 860. In response to the received pre-processed input signal, the gate signal circuit portion 860 generates and drives a gate signal for a voltage controlled switching device, e.g., the high-side switch of a half-bridge assembly, the low-side switch of a half-bridge assembly, or a switch in a single-ended switching assembly.

The gate signal circuit portion 860 may include a gate driver logic circuit 622 and a gate driver stage 690 as described with reference to FIGS. 7 and 8. The gate driver logic circuit 622 may define idle phases at the start and at the end of active periods of the gate signal. The gate driver stage 690 outputs the gate signal at a gate driver output Gout.

In addition, the gate driver portion 851 may include a control circuit 861. The control circuit 861 may output a first single-switch control signal SCout1 or a first and a second single-switch control signal SCout1, SCout2. The control circuit 861 and the gate driver logic circuit 622 may be merged, may be formed side-by-side or may be interleaved. The control circuit 861 may output the first single-switch control signal SCout1 at a first output control node 866. In addition, the control circuit 861 may output the second single-switch control signal SCout2 at a second output control node 868.

The first control output node 866 may be electrically directly connected to a first single-switch control terminal SCtrl1 of the gate driver portion 851. Accordingly, the second control output node 868 may be electrically directly connected to a second single-switch control terminal SCtrl2 of the gate driver portion 851.

In the illustrated embodiment the first auxiliary switch 662 as described with reference to FIGS. 5, 6A and 7 is integrated in the single-ended gate driver device 850. The first control output node 866 is electrically connected to a gate input node of the integrated first auxiliary switch 662, one of the load terminal nodes of the first auxiliary switch 662 is electrically connected to the first single-switch control terminal SCtrl1, and the other one of the load terminal nodes of the first auxiliary switch 662 is electrically connected or coupled to the gate driver output Gout.

Accordingly, the second auxiliary switch 665 as described with reference to FIGS. 6A and 7 may be integrated in the single-sided gate driver device 850. The second control output node 868 may be electrically connected to a gate input node of the integrated second auxiliary switch 665, one of the load terminal nodes of the second auxiliary switch 665 may be electrically connected to the second single-switch control terminal SCtrl2, and the other one of the load terminal nodes of the second auxiliary switch 665 may be electrically connected to one of the supply voltage rails, e.g., to +VH.

The first single-switch control signal SCout1 may be or may approximate the inverted gate signal Gout. Short time delays at the start and at the end of the active phase of the first single-switch control signal Scout1 may avoid interference between the active gate output signal and the auxiliary current.

As illustrated in FIG. 12B, after the gate output signal Gout becomes inactive at t = t01, the first single-switch control signal SCout1 becomes active at t = t1. The first single-switch control signal SCout1 becomes inactive at t = t2 shortly before the gate output signal Gout becomes active at t = t02.

The second single-switch control signal SCout2 may be or may approximate the inverted first single-switch control signal SCout1. Short time delays at the start and at the end of the active phase of the second single-switch control signal SCout2 may avoid interference with the first single-switch control signal SCout1.

After the first single-switch control signal SCout1 becomes inactive at t = t2, the second single-switch control signal SCout2 becomes active at t = t21. The second single-switch control signal SCout2 becomes inactive at t = t11 shortly before the first single-switch control signal SCout1 becomes active at t = t1.

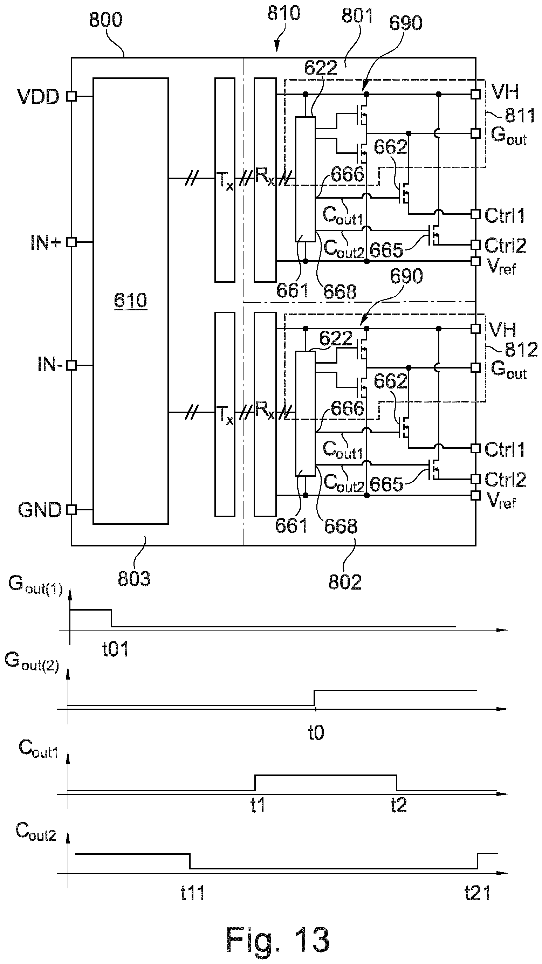

FIG. 13 shows a half-bridge gate driver device 800 that includes an input portion 803, a first gate driver portion 801 and a second gate driver portion 802. The input portion 803 receives an input signal at input terminals In+, In-. The input signal may include square pulses and may be received from a pulse width modulator circuit. The input portion 803 may pre-process the input signal and may transfer the pre-processed input signal to the first and second gate driver portions 801, 802, which may be electrically insulated from each other and from the input portion 803.

The first gate driver portion 801 includes a first gate signal circuit portion 811. In response to the received pre-processed input signal, the first gate signal circuit portion 811generates and drives a first gate signal for a first voltage controlled switching device, e.g., the low-side switch of a half-bridge assembly.

The first gate signal circuit portion 811may include a gate driver logic circuit 622 and a gate driver stage 690 as described with reference to FIGS. 7 and 8. The gate driver logic circuit 622 may define the idle phases between active periods of the first gate signal and a second gate signal output by the second gate driver portion 802. The gate driver stage 690 outputs the first gate signal at a first gate driver output Gout.

In addition, the first gate driver portion 801 may include the control circuit 661 as described with reference to any of FIGS. 2, 5, or 6A., wherein the control circuit 661 may output the first control signal or the first and second control signals Cout1, Cout2 as described above. The control circuit 661 and the gate driver logic circuit 622 may be merged, may be formed side-by-side or may be interleaved. The control circuit 661 may output the first control signal Cout1 at a first output control node 666. In addition, the control circuit 661 may output the second control signal Cout2 at a second output control node 668.

The first control output node 666 may be electrically directly connected to a first control terminal Ctrl1 of the first gate driver portion 801. Accordingly, the second control output node 668 may be electrically directly connected to a second control terminal Ctrl2 of the first gate driver portion 801.

In the illustrated embodiment the first auxiliary switch 662 as described with reference to FIGS. 5, 6A and 7 is integrated in the half-bridge gate driver device 800. The first control output node 666 is electrically connected to a gate input node of the integrated first auxiliary switch 662, one of the load terminal nodes of the first auxiliary switch 662 is electrically connected to the first control terminal Ctrl1, and the other one of the load terminal nodes of the first auxiliary switch 662 is electrically connected or coupled to the gate driver output Gout.

Accordingly, the second auxiliary switch 665 as described with reference to FIGS. 6A and 7 may be integrated in the gate driver device 800. The second control output node 668 may be electrically connected to a gate input node of the integrated second auxiliary switch 665, one of the load terminal nodes of the second auxiliary switch 665 may be electrically connected to the second control terminal Ctrl2, and the other one of the load terminal nodes of the second auxiliary switch 665 may be electrically connected to one of the supply voltage rails, e.g., to +VH.

The second gate driver portion 802 may generate and drive a second gate signal at a second gate driver output Gout for a second voltage controlled switching device, e.g., the high-side switch of the half-bridge. The internal configuration of the first and second gate driver circuits 801, 802 may be identical or at least almost identical.

For illustration, various scenarios have been described with respect to a silicon carbide device. Similar techniques may be implemented in semiconductor devices based on other kinds and types of semiconductors material, e.g., silicon (Si), germanium (Ge), gallium nitride (GaN) or gallium arsenide (GaAs), etc.

Also for illustration, various techniques have been described with respect to MOSFETs. Similar techniques may be implemented in other kinds and types of semiconductor devices with insulated gate transistor cells such as MGDs and IGBTs, in particular RC-IGBTs (reverse conducting IGBTs).

Further for illustration, various techniques have been described with respect to two gate drivers integrated in a half-bridge gate driver circuit. Similar techniques may be implemented providing different degrees of integration of functional blocks of a half-bridge gate driver. For example, the first gate driver portion and the second gate driver portion may be separated devices receiving the same input signal or two different input signals, wherein one of the input signals may be a phase-shifted or inverted version of the other input signal.

## Claims

1. A semiconductor switching assembly comprising:
a gate driver circuit (600) configured to drive a gate signal for a voltage controlled switching device (590), wherein the gate signal is output between a gate output terminal (Gout) and a reference voltage terminal (Vref), and wherein the gate signal may assume an active state and an inactive state;
a diode structure (550) electrically arranged between the gate output terminal (Gout) and the reference voltage terminal (Vref), wherein the diode structure (550) is arranged to be reverse biased when the voltage controlled switching device (590) is on; and
a supplementary circuit (660) configured to temporarily impose a forward current (IF) through the diode structure (550).

2. The semiconductor switching assembly according to the preceding claim, further comprising:
a voltage controlled switching device (590) comprising a gate input terminal (G), a first load terminal (L1) and a second load terminal (L2), wherein the gate input terminal (G) is electrically connected to the output terminal (Gout) of the gate driver circuit (600), and wherein the first load terminal (L1) is electrically connected to the reference voltage terminal (Vref).

3. The semiconductor switching assembly according to the preceding claim, wherein:
the supplementary circuit (660) is configured to impose the forward current (IF) through the diode structure (550) prior to and during a transition from a low voltage of a first polarity to a high voltage of a second polarity between the second load terminal (L2) and the first load terminal (L1).

4. The semiconductor switching assembly according to any of the preceding claims, wherein
a semiconductor device (500) comprises the diode structure (550) and the voltage controlled switching device (590).

5. The semiconductor switching assembly according to any of the preceding claims, wherein
the supplementary circuit (660) comprises a controllable current source (669), wherein a switchable current path of the current source (669) is electrically connected between the gate output terminal (Gout) and the reference voltage terminal (Vref) or wherein the switchable current path is electrically connected between the gate output terminal (Gout) and a complementary voltage rail (670), wherein a voltage between the complementary voltage rail (670) and the reference voltage terminal (Vref) has a polarity opposite to a polarity of a gate threshold voltage (VG(th)).

6. The semiconductor switching assembly according to any of the preceding claims, wherein
the supplementary circuit (660) comprises a first auxiliary switch (662) and a passive element (663), wherein the first auxiliary switch (662) and the passive element (663) are electrically arranged in series between the gate output terminal (Gout) and a complementary voltage rail (670), wherein a voltage between the complementary voltage rail (670) and the reference voltage terminal (Vref) has a polarity opposite to a polarity of a gate threshold voltage (VG(th)).

7. The semiconductor switching assembly according to any of the preceding claims, wherein
the supplementary circuit (660) comprises a first auxiliary switch (662) and an energy storage element (664), wherein the first auxiliary switch (662) and the energy storing element (664) are arranged such that the first auxiliary switch (662) temporarily connects the energy storing element (664) in series between the gate output terminal (Gout) and the reference voltage terminal (Vref).

8. The semiconductor switching assembly according to any of the preceding claims, wherein
the supplementary circuit (660) comprises a first auxiliary switch (662) and an inductor (664), wherein the first auxiliary switch (662) and the inductor (664) are electrically arranged in series between the gate output terminal (Gout) and the reference voltage terminal (Vref), and wherein the inductor (664) is temporarily electrically connectable to a supply voltage rail (671) supplied with a supply voltage (Vpos) having a same polarity as a gate threshold voltage of the voltage controlled switching device (590).

9. The semiconductor switching assembly according to any of the preceding claims, wherein
a gate driver device (800) comprises the gate driver circuit (600) and a control circuit (661) of the supplementary circuit (660).

10. A half-bridge gate driver device comprising:
a gate signal circuit (810) configured to generate and drive a first gate signal for a first voltage controlled switching device and to generate and drive a second gate signal for a second voltage controlled switching device, wherein the first gate signal is inactive when the second gate signal is active and wherein the second gate signal is inactive when the first gate signal is active; and
a control circuit (661) comprising a first control output node (666) and configured to generate a first control signal (Cout1) at the first control output node (666), wherein
the first control signal (Cout1) becomes active after a transition of the first gate signal from active to inactive and prior to a subsequent transition of the second gate signal from inactive to active, and
the first control signal (Cout1) becomes inactive after the transition of the second gate signal from inactive to active and prior to a subsequent transition of the first gate signal from inactive to active.

11. The half-bridge gate driver device according to the preceding claim, further comprising:
a first control terminal (Ctrl1) electrically connected to the first control output node (666).

12. The half-bridge gate driver device according to claim 10, further comprising:
a first control terminal (Ctrl1) and a first auxiliary switch (662), wherein the first control output node (666) is electrically connected to a gate input node of the first auxiliary switch (662) and wherein one of the load terminal nodes of the first auxiliary switch (662) is electrically connected to the control terminal (Ctrl1) .

13. A single-switch gate driver device comprising:
a gate driver circuit (600) configured to drive a gate signal for a voltage controlled switching device; and
a control circuit (861) comprising a first control output node (868) and configured to generate a first single-switch control signal at the first control output node (868), wherein
the first single-switch control signal becomes active with or after a transition of the gate signal from active to inactive, and
the first single-switch control signal becomes inactive with or prior to a subsequent transition of the gate signal from inactive to active.

14. The single-switch gate driver device according to the preceding claim, further comprising:
a first single-switch control terminal (SCtrl1) and a first auxiliary switch (661), wherein the first control output node (868) is electrically connected to a gate input node of the first auxiliary switch (661) and wherein one of the load terminal nodes of the first auxiliary switch (661) is electrically connected to the first single-switch control terminal (SCtrl1).
